# EUROPEAN PATENT SPECIFICATION

(11) **EP 0 465 261 B1**
(45) Date of publication and mention of the grant of the patent: **03.05.1995**
(21) Application number: 91306110.7
(22) Date of filing: 04.07.1991
(51) Int. Cl.: H01R 13/58

(54) **Improvements relating to multi-core cable connectors**
Steckverbinder für Mehrleiterkabel
Connecteur pour câbles à plusieurs conducteurs

(30) Priority: 04.07.1990 JP 176598/90
(43) Date of publication of application: 08.01.1992
(73) Proprietor: MOJI & CO., LTD, Nishitama-gun, Tokyo (JP)
(72) Inventor: Moji, Eiro, Nishitama-gun, Tokyo (JP)
(74) Representative: Moore, Anthony John

(56) References cited:
- DE-A- 2 051 914

## Description

This invention relates to improvements in multi-core connectors for connecting a multi-core cable to electrical apparatus such as a transformer, radio, tape recorder or to a co-operating connector, and is intended to prevent the cable from coming out of the connector when the cable is pulled.

Conventional means for preventing a cable connected to a multi-core connector from being pulled out is as follows: a clamp having the form of a C-shaped snap ring or a ratchet-type cable tie is passed around the end portion of the cable at a position just inset from the point at which the cores project, and the clamp is then tightened around the periphery of the cable so as to reduce its diameter along the clamped length. The tightened clamp engages in engaging means formed around the cable outlet of the connector so as to secure the cable against axial movement relatively to the connector. Alternatively, at the cable outlet of the body of a connector formed of co-operating upper and lower portions, there are formed in one portion a projection projecting centrally from the internal wall surface towards the centre of the cable outlet and in the other portion projections projecting from each side of the centre line of the cable outlet: when the cable is pushed into the cable outlet it is thus forced to follow a sinuous path and is held against the internal surfaces of the cable outlet.

However, although these conventional arrangements ensure that the outside surface of the cable is securely attached to the connector, the attachment between the outer sheath of the cable and the inner insulating sleeve around each core is insufficient. When the cable is pulled strongly, the outer sheath is stretched and the inner sleeves are also stretched. Therefore, over the length where the outer sheath of the cable is clamped, the inner sleeves covering the cores move in an axial direction relatively to the outer sheath, together with the cable cores. As a result, the connections between the cable cores and the connection terminals of the connector become disconnected. Moreover, as a result of this axial movement the insulating sleeve around each core is elongated and its diameter consequently reduced. Consequently the grip on the cable by the clamp is relaxed and the cable can be easily pulled out of the clamp.

DE-A-2051914 discloses a connector for a multi-lead cable in which a post secured to the connector is provided with a groove into which the leads are wedged by a clamp.

The object of the present invention is to overcome the above-mentioned disadvantages of the prior art arrangements and to ensure that the cable is firmly held within the connector, even though the cable is pulled strongly.

We have discovered that the cable cannot be effectively held within the cable outlet simply by improving the clamping means for squeezing the periphery of the cable so that the inner layer around each core, as well as the outer sheath, is tightened up, even though the the maximum clamping force is exerted. Accordingly the insulating sleeves remain almost unaffected by the clamping force. It is these factors which cause the above-described problems.

However, when according to the present invention a hard wedge is inserted axially into the cable between the individually insulated cores and the cable is clamped around the wedge, it was found that the cable could be fixed extremely securely and was very resistant to being pulled from the connector.

Some embodiments of the invention will now be described with reference to the accompanying drawings, in which:
Fig. 1 is an exploded perspective view showing the construction of a multi-core cable connector in accordance with the present invention;
Fig. 2 is a cross-section of the cable shown in Fig. 1;
Fig. 3 is a side elevation of one form of a wedge utilisable in the embodiment of Fig. 1;
Fig. 4 is an end elevation of the wedge of Fig. 3;
Fig. 5 is a side elevation of another form of wedge;
Fig. 6 is an end elevation of the wedge of Fig. 5;
Fig. 7 is a side elevation of yet another form of wedge;
Fig. 8 is an end elevation of the wedge of Fig. 7;
Fig. 9 is an end elevation of a modification of the wedge of Fig. 7;
Fig. 10 is a side elevation of still another form of wedge;
Fig. 11 is an end elevation of the wedge;
Fig. 12 is a side elevation of a yet further form of wedge;
Fig. 13 is a side elevation of a still further form of wedge;
Fig. 14 is an end elevation of the wedge of Fig. 13;
Fig. 15 is a side elevation of still another form of wedge;
Fig. 16 is an end elevation of the wedge of Fig. 15;
Fig. 17 is an end elevation of a modification of the wedge of Fig. 15;
Fig. 18 is an end elevation of a different modification of the wedge of Fig. 15;
Fig. 19 is a side elevation of a yet still further form of wedge
Fig. 20 is a perspective view of one form of clamp utilisable in the embodiment of Fig. 1;
Fig. 21 is a perspective view of another form of clamp;
Fig. 22 is a side elevation partly in section of a connector being subjected to a tension test; and
Figs. 23, 24 and 25 are longitudinal sections of various embodiments of the present invention being subjected to a tension test.

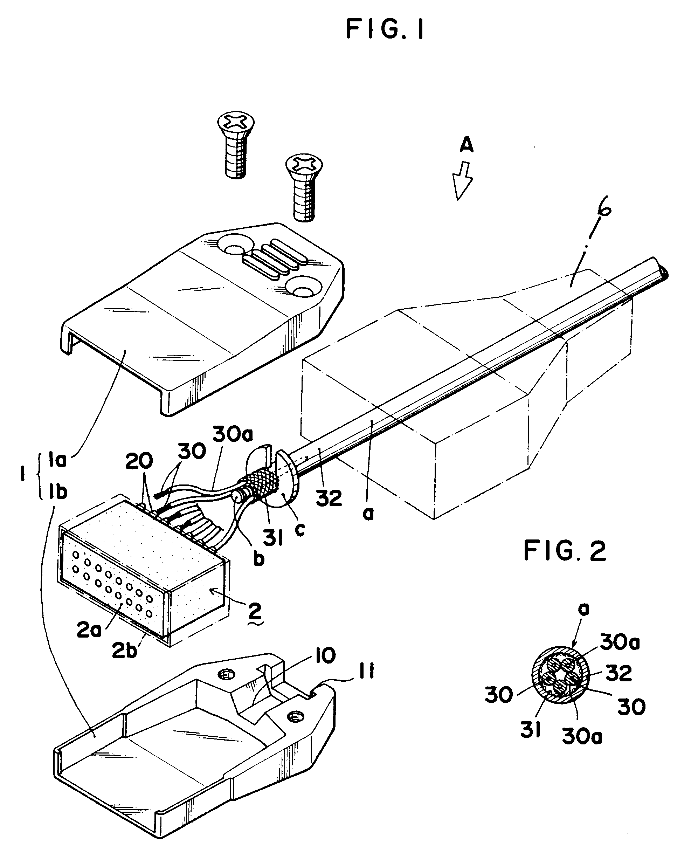

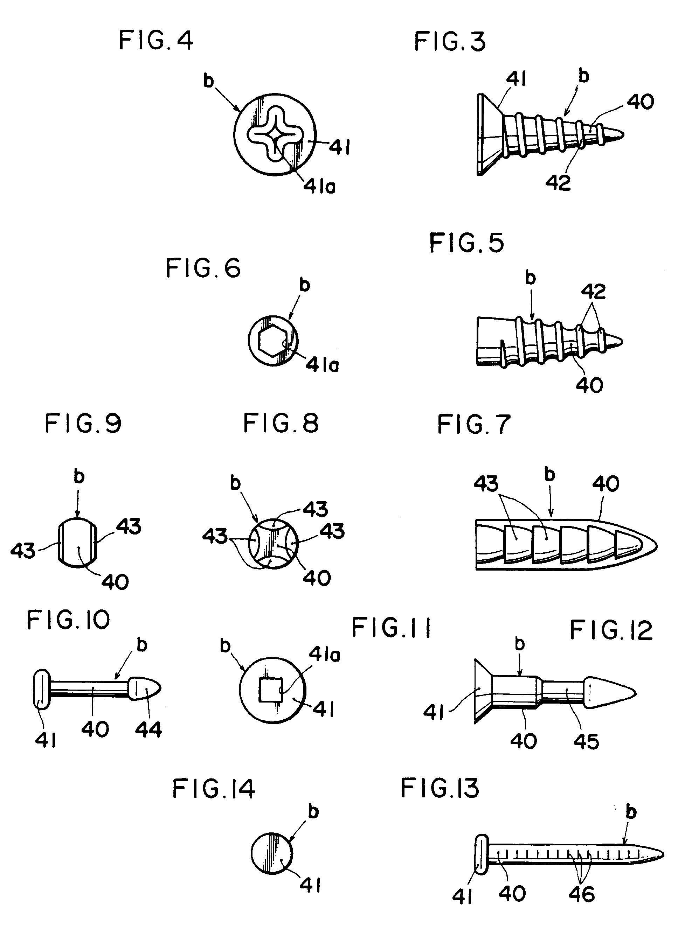

Fig. 1 shows a multi-core connector A for connecting a cable a to the connector pins (not shown) of electrical apparatus such as a transformer, which connector comprises a casing 1, a connector block 2, a wedge b and a clamp c.

The casing 1 is formed of metal or synthetic resin and comprises an upper shell 1a and a lower shell 1b which can be clamped together by screws 1c in the normal way around the connector block 2 which has a body 2a moulded from synthetic resin and housing a number of socket contacts 20. When the casing 1 is moulded from a synthetic resin, the connector block 2a is surrounded by an external metal casing 2b shown in chain-dot line in Fig. 1.

The cable a is an ordinary cable as shown in Fig. 2. Each core 30 in the cable a is covered with a sleeve 30a of an insulating material such as a synthetic resin material and the cores together form a bundle which is immediately surrounded by a reticulated wire shield 31, and further surrounded by an outer sheath 32, again made of insulating material such as synthetic resin. The cable a may omit the shield 31 and contain any number of cores 30 provided that the number of cores is more than two.

The wedge b may be made of metal or synthetic resin and, as shown in Figs. 3 and 4, resemble a wood screw, the wedge b comprising a slowly tapering conical body 40 from which projects a spiral thread 42 and which is formed at its base with an integral wider diameter head 41.

Figs. 5 and 6 show a modification of the wedge of Fig. 3 and 4 in which the projecting spiral thread 42 is formed by shaping the conical main body 40, and which does not have the head portion 41. Moreover, it should be noted, the screw-form wedges may be of constant diameter, in other words be of cylindrical form.

In the form of the wedge b shown in Figs. 7 and 8, the projecting spiral thread 42 is replaced by four axially-extending rows of teeth 43 having rounded front faces and rear faces lying in a radial plane. Alternatively, only two rows of such teeth may be employed, as shown in Fig. 9. Clearly other numbers of rows of teeth may be employed, as appropriate.

In the form of the wedge b shown in Figs. 10 and 11 the main body 40 is constituted by a shank having at one end an integral, enlarged diameter head 41. At its other end the body 40 terminates in a nose 44 of generally conical form: this form of wedge thus resembles a harpoon.

It will be noted that in each of the above-described embodiments the head 41 is formed with a recess 41a for receiving an insertion tool.

Fig. 12 shows a modification of the wedge of Figs. 10 and 11 having a reduced diameter portion 45. When a reduced diameter portion 45 is employed, the head portion 41 may be omitted.

Figs. 13 and 14 show a further form of cylindrically-bodied wedge b having an enlarged head portion 41 at one end of the body 40 and a pointed end at the other, the wedge thus resembling a nail. A series of transverse ridges or grooves 46 is formed in the axial direction along the body 40. In an alternative embodiment the head portion 41 may be omitted.

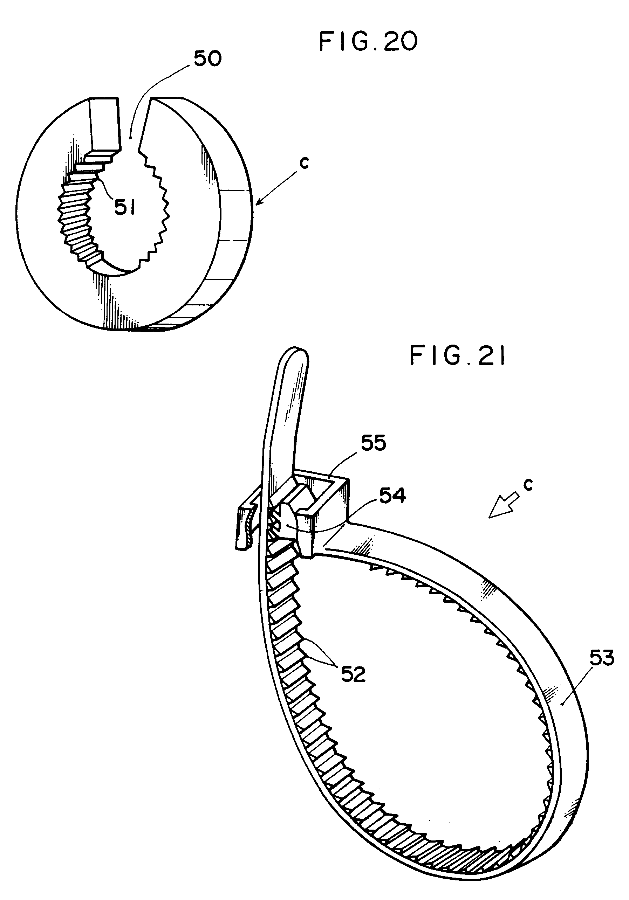

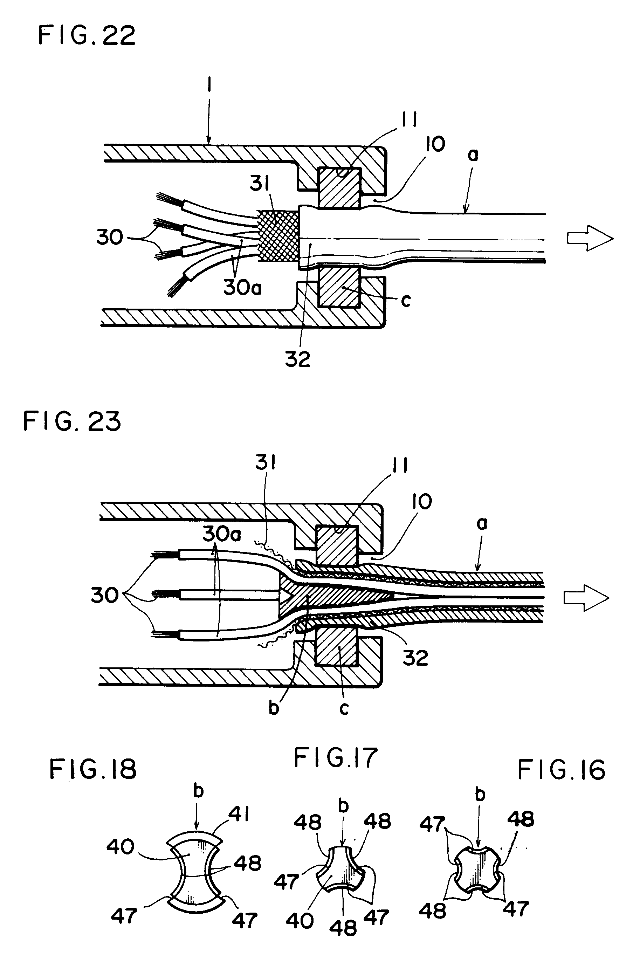

Figs. 15 and 16 show a further modification of the wedge b having a generally cylindrical body 40. However, the body is formed with four arcuate-section grooves 47 each for receiving cable core 30 and insulating sleeve 30a of a four-core cable a. In the case of a three-core cable the body 40 is formed with three grooves, equally disposed in the radial direction, as shown in Fig. 17. In the case that the cable a is a two-core cable 30, a diametrically opposed pair of grooves 47 is provided, as shown in Fig. 18. In each of the embodiments of Figs. 15 to 18, the grooves 47 may be formed with transverse ridges 48 projecting from the internal surfaces thereof.

For certain applications, the grooves 47 may extend in the longitudinal direction only as far as a reduced diameter portion 45, as shown in Fig. 12. The enlarged diameter head may be omitted, as shown in the headless Fig. 19 version.

The clamp c may be a conventional clamp made either of metal or of synthetic resin. In the embodiment shown in Fig. 20 it takes the form of a C-shaped snap ring having a circumferential opening 50 and axially-extending serrations 51 on its internal surface.

In an alternative form shown in Fig. 21, the clamp c takes the form of a cable tie comprising a flexible synthetic resin strap 53 having teeth 52 on its internal surface, and at one end an integral collar 55 provided with ratchet pawls 54 for engagement with the teeth 52. After the strap 53 has been passed around the cable a the free end is passed through the collar 55.

To fit the cable connector A terminal lengths of the outer sheath 32 and the shield 31 are first stripped in the usual way to expose the end portions of the cores 30, but allowing a short length of the shield 31 to project. The wedge b is then inserted axially between the cores 30 at the point where they enter the outer sheath 32. Where the wedge b is threaded as in the embodiments of Figs. 3 to 6 insertion is of course facilitated by screwing in the wedge b, rotation being effected by means of an appropriate tool inserted into the recess 41a. In the case of the remaining embodiments the wedge b is simply pushed in, using an insertion tool if the head is provided with an appropriate recess 41a.

The clamp c is then placed around the cable a at a position slightly inset from the end of the outer skin 32, and tightened. In the case of the C-shaped clamp of Fig. 20, the clamp is passed around the cable a by springing it open at the opening 50 and then crimped with an appropriate tool, compressing the outer sheath 32 of the cable a and pressing the insulating sleeves 30a hard against the wedge b.

The cable tie clamp of Fig. 21 is of course tightened by pulling on the free end of the strap 53. Whatever the type of clamp a employed, it may if desired be first placed in position around the cable before insertion of the wedge b and subsequently tightened.

Where the wedges b of Figs. 10 to 12 are employed care must of course be taken to ensure that the clamp c is positioned over the shank-form body 40 and the reduced diameter portion 45, respectively.

The end portion of the cable a thus completely tightened up by the clamp c around the wedge b is then inserted into a cable outlet 10 defined by the upper shell 1a and the lower shell 1b of the casing 1, with the bared ends of the cores 30 having been connected to the respective contacts 20 in the connector block 2. The tightened clamp c is thus engaged in the channel 11 provided in each shell 1a, 1b adjacent to the cable outlet 10. The upper shell 1a and the lower shell 1b are then clamped together by screwing home the screws 1c, and the cable a is positively retained within the assembled casing 1.

If the casing 1 is formed of a metallic material, the outer surface of the casing 1 is covered with a synthetic resin cover 6 which has previously been threaded onto the cable a. Alternatively, the cover 6 is moulded in situ around the junction of the cable a with the casing 1.

By the above-described procedure, the periphery of the cable a is tightened up by the clamp c around the hard wedge b which has been drawn axially between the cores of the cable a. As a result, the radially inner portion of each insulating sleeve 30a is pressed against, and firmly engaged with, the adjacent surface of the wedge b. At the same time, the tightened clamp c beds into the constricted outer sheath 32, particularly if the wedge b is of one of the forms shown in Figs. 10 to 12. By virtue of the compressive force exerted by the clamp c around the wedge b, the outer sheath 32 is strongly adhered to the insulating sleeves 30a thus achieving virtually integral engagement. Moreover, the cores 30 are each tightly held against their respective sleeves 30a.

As a result of the clamp c being thus tightened up around the cable a and being also engaged in channel 11 at the cable outlet 10, the cable a becomes extremely resistant to pulling.

In other words, the portions of the cable a tightened up by the clamp c become an integral rod-like rigid body interposed between the clamp c and the wedge b, and firmly held in the casing 1. Also, the reduction in cable diameter due to the elongation of the outer skin 32 and the inner skin 30a when the cable a is strongly pulled are hardly evident at the portion embraced by the clamp c. Accordingly, the cable a connected to the connector A as described above is remarkably strongly resistant to pulling.

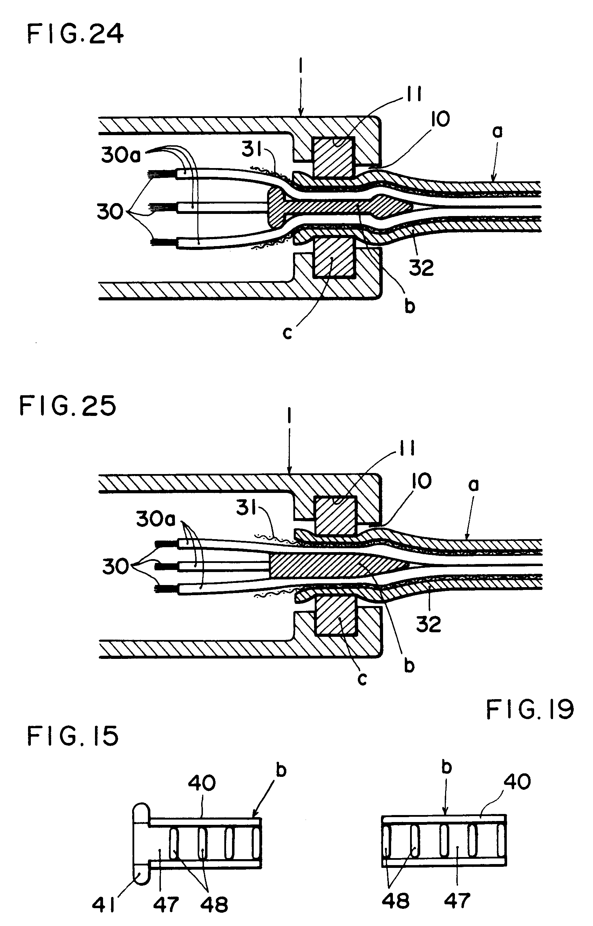

Some results of tension tests conducted on a four-core cable a are as follows: Using a clamp c but without using a wedge b as shown in Fig. 22, the resistance to tension was within the range of 3 to 8 Kg. In the case of using the wedge b in a screw form as shown in Fig. 3, the resistance was more than 20 Kg; in the case of using the wedge b in a harpoon form as shown in Fig. 12, the resistance was within the range of 14 to 16 Kg; and in the case of using the wedge b in the form of a headless nail as shown in Fig. 25, the resistance was within the range of 9 to 11 Kg.

## Claims

1. A multi-core cable connector for fitting to a multi-core cable (a) comprising cores 30 each surrounded by an insulating sleeve (30) and an outer sheath (32), the connector including a casing (1) having a cable outlet (10) provided with engagement means (11) for engagement with a clamp (c) for clamping the cable (a) where it passes through the outlet (10), characterised in that the connector (A) also comprises a wedge (b) spaced apart from the casing and the connector and inserted axially between the cores (39) into the length to be clamped, such that on tightening the clamp (c) the outer sheath (32) of the cable (a) is firmly pressed against the insulating sleeves (30a) around each core (30), and the insulating sleeves (30a) are firmly pressed against the wedge (b) such that the cable a becomes strongly resistant to being pulled from the connector (A).

2. A connector as claimed in claim 1, wherein said wedge (b) is a screw having a spiral thread (42) formed around the surface of a frusto-conical body (40).

3. A connector as claimed in claim 1, wherein at least two rows of transverse teeth or serrations (43) or transverse ridges (46) are arranged along the body (40) of said wedge (b).

4. A connector as claimed in claim 1, wherein said wedge (b) is of harpoon-like form having at one end of the body (40) an enlarged diameter conical portion (44).

5. A connector as claimed in claim 1, wherein said wedge (b) is of nail-like form and has a point at one end of the body ( 40 ).

6. A connector as claimed in claim 1, wherein a plurality of axially-extending and equally-spaced grooves (47) is formed along the body (40) of the wedge (b), each for receiving a respective insulated core (30).

7. A connector as claimed in claim 6, wherein transverse ridges (48) are formed along each groove (47).

8. A connector as claimed in any one of claims 2 to 7, wherein said wedge (b) is provided with an enlarged diameter head portion (41) at the other end of the body (40).

9. A connector as claimed in claim 8, wherein said head portion (41) is formed with a recess (41a) for reception of an insertion tool.

10. A connector as claimed in any preceding claim and fitted to a multi-core cable (a).

## Patentansprüche

1. Steckverbinder für Mehrleiterkabel zum Befestigen auf einem Mehrleiterkabel (a) umfassend jeweils von einer isolierenden Hülle (30a) umgebene Leiter (30) und eine äußere Hülle (32), wobei der Steckverbinder ein Gehäuse (1) enthält, welches einen Kabelauslaß (10) besitzt, der mit Eingriffsmitteln (11) zum Eingreifen in eine Klemmvorrichtung (c) zum Klemmen des Kabels (a) beim Passieren des Auslasses (10) versehen ist, dadurch gekennzeichnet, daß der Steckverbinder (A) darüber hinaus einen Füllkeil (b) umfaßt, der vom Gehäuse und vom Steckverbinder beabstandet und axial zwischen die Leiter (30) über den zu klemmenden Längsabschnitt eingesetzt ist, derart, daß beim Zusammenklemmen der Klemmeinrichtung (c) die äußere Hülle (32) des Kabels (a) fest gegen die isolierenden Hülsen (30a) um jeden Leiter (30) gepreßt wird und daß die isolierenden Hülsen (30a) fest gegen den Füllkeil (b) gepreßt werden, so daß das Kabel (a) eine hohe Widerstandskraft gegen ein Herausziehen aus dem Steckverbinder (A) erhält.

2. Steckverbinder nach Anspruch 1, bei dem der Füllkeil (b) eine Schraube mit einem Spiralgewinde (42) ist, welches rund um die Oberfläche eines kegelstumpfförmigen Körpers (40) geformt ist.

3. Steckverbinder nach Anspruch 1, wobei wenigstens zwei Reihen transversaler Zähne oder Riffelungen (43) oder transversaler Rippen (46) längs des Körpers (40) des Füllkeils (b) angeordnet sind.

4. Steckverbinder nach Anspruch 1, bei dem der Füllkeil (b) eine harpunenartige Form hat, wobei an einem Ende des Körpers (40) ein im Durchmesser erweiterter konischer Abschnitt (44) vorgesehen ist.

5. Steckverbinder nach Anspruch 1, bei dem der Füllkeil (b) nagelförmige ausgebildet ist und am einen Ende des Körpers (40) eine Spitze aufweist.

6. Steckverbinder nach Anspruch 1, bei dem eine Mehrzahl von sich axial erstreckenden und in gleichen Abständen angeordneten Nuten (47) längs des Körpers (40) des Füllkeils (b) eingeformt sind, von denen jede zur Aufnahme jeweils eines isolierten Leiters (30) dient.

7. Steckverbinder nach Anspruch 6, wobei Querrippen (48) längs jeder Nut (47) angeformt sind.

8. Steckverbinder nach einem der Ansprüche 2 bis 7, bei welchem der Füllkeil (b) am anderen Ende des Körpers (40) mit einem Kopfabschnitt (41) mit vergrößertem Durchmesser versehen ist.

9. Steckverbinder nach Anspruch 8, wobei der Kopfabschnitt (41) mit einer Ausnehmung (41a) zur Aufnahme eines Einsatzwerkzeugs versehen ist.

10. Steckverbinder nach einem der vorhergehenden Ansprüche, montiert auf einem Mehrleiterkabel.

## Revendications

1. Connecteur pour câble multiconducteur devant s'adapter à un câble multiconducteur (a) comprenant des conducteurs 30 dont chacun est entouré d'une gaine isolante (30) et un manchon extérieur (32), le connecteur comprenant un boîtier (1) ayant une sortie de câble (10) munie d'un moyen d'engagement (11) pour s'engager avec un serre-câble (c) pour serrer le câble (a) au point où il passe par la sortie (10), caractérisé en ce que le connecteur (A) comprend aussi une clavette (b) espacée du boîtier et du connecteur et insérée axialement entre les conducteurs (39) dans la longueur à serrer, de telle sorte que lorsqu'on serre le serre-câble (c), le manchon extérieur (32) du câble (a) est fermement pressé contre les gaines isolantes (30a) autour de chaque conducteur (30) et les gaines isolantes (30a) sont fermement pressées contre la clavette (b) de telle sorte que le câble a devient fortement résistant à la traction d'arrachement au connecteur (A).

2. Connecteur selon revendication 1, dans lequel ladite clavette (b) est une vis ayant un filetage spiralé (42) formé autour de la surface d'un corps tronconique (40).

3. Connecteur selon revendication 1, dans lequel au moins deux rangées de dents transversales ou de stries (43) ou d'arêtes transversales (46) sont disposées le long du corps (40) de ladite clavette (b)

4. Connecteur selon revendication 1, dans lequel ladite clavette (b) a une forme de harpon, et comporte à une extrémité du corps (40) une partie conique de diamètre agrandi (44).

5. Connecteur selon revendication 1, dans lequel ladite clavette (b) a la forme d'un clou et a une pointe à une extrémité du corps (40).

6. Connecteur selon revendication 1, dans lequel une pluralité de rainures disposées axialement et également espacées (47) sont formées le long du corps (40) de la clavette (b), chacune recevant respectivement un conducteur isolé (30).

7. Connecteur selon revendication 6, dans lequel des arêtes transversales (48) sont formées le long de chaque rainure (47).

8. Connecteur selon l'une quelconque des revendications 2 à 7, dans lequel ladite clavette (b) est munie d'une partie tête (41) de diamètre agrandi à l'autre extrémité du corps (40).

9. Connecteur selon revendication 8, dans lequel ladite partie tête (41) est formée avec un évidement (41a) pour recevoir un outil d'insertion.

10. Connecteur selon l'une quelconque des revendications précédentes et monté sur un câble multiconducteur (a).
